(19) Europäisches Patentamt
European Patent Office
Office européen des brevets

(11) **EP 2 541 778 A1**

(12) **EUROPEAN PATENT APPLICATION**
published in accordance with Art. 153(4) EPC

(43) Date of publication:
**02.01.2013 Bulletin 2013/01**

(21) Application number: **11747059.1**

(22) Date of filing: **24.02.2011**

(51) Int Cl.:
**H03M 13/27** (2006.01)

(86) International application number:
**PCT/JP2011/001079**

(87) International publication number:
**WO 2011/105092 (01.09.2011 Gazette 2011/35)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.02.2010 JP 2010038888**

(71) Applicants:
• **Panasonic Mobile Communications Co., Ltd.
Yokohama-shi
Kanagawa 224-8539 (JP)**
• **NTT DoCoMo, Inc.
Chiyoda-Ku
Tokyo 100-6150 (JP)**

(72) Inventors:
• **MATO, Manabu
Sendai-shi, Miyagi 981-3206 (JP)**
• **HASHIMOTO, Kazunari
Senday-shi, Miyagi 981-3206 (JP)**

(74) Representative: **Grünecker, Kinkeldey,
Stockmair & Schwanhäusser
Leopoldstrasse 4
80802 München (DE)**

(54) **INTERLEAVING DEVICE AND INTERLEAVING METHOD**

(57) Disclosed are an interleaving device and an interleaving method which shorten processing time for channel interleaving. A CQI memory writing unit (101) writes the CQI in symbol units in the row direction from the head of the memory (103) selected as a channel interleaving line. The DATA memory writing unit (102) continues from the CQI writing end address number and symbol number and writes the DATA in symbol units in the row direction of the memory (103) selected as the channel interleaving line. The memory reading unit (104) reads the stored CQI and DATA from the memory (103) according to the channel interleaving line mapping, from the head of the memory (103) in the row direction in symbol units. The data multiplexing unit (105) multiplexes RI channel interleaving data and ACK channel interleaving data with the read CQI and DATA and outputs it as channel interleaving data.

FIG.10

**Description**

Technical Field

The present invention relates to an interleaving apparatus and an interleaving method that perform channel interleaving processing on an uplink shared channel (UL-SCH) in a Long Term Evolution (LTE) system of 3GPP (3rd Generation Partnership Project), which is a standardization group of a third generation mobile communication system.

Background Art

In radio communication, burst errors occur due to fading. Such burst errors prevent error correction codes from making full use of its capability. Accordingly, using the error correction codes alone has limitations in enhancing error resilience. In such a case, use of interleaving is known as a technique for randomizing an error sequence. This interleaving technique is indispensable in radio communication. The interleaving technique is also applied to transmit a signal using UL-SCH of 3GPP LTE and disclosed more specifically in Non-Patent Literature 1 or the like. Hereinafter, the interleaving processing described in Non-Patent Literature 1 will be described.

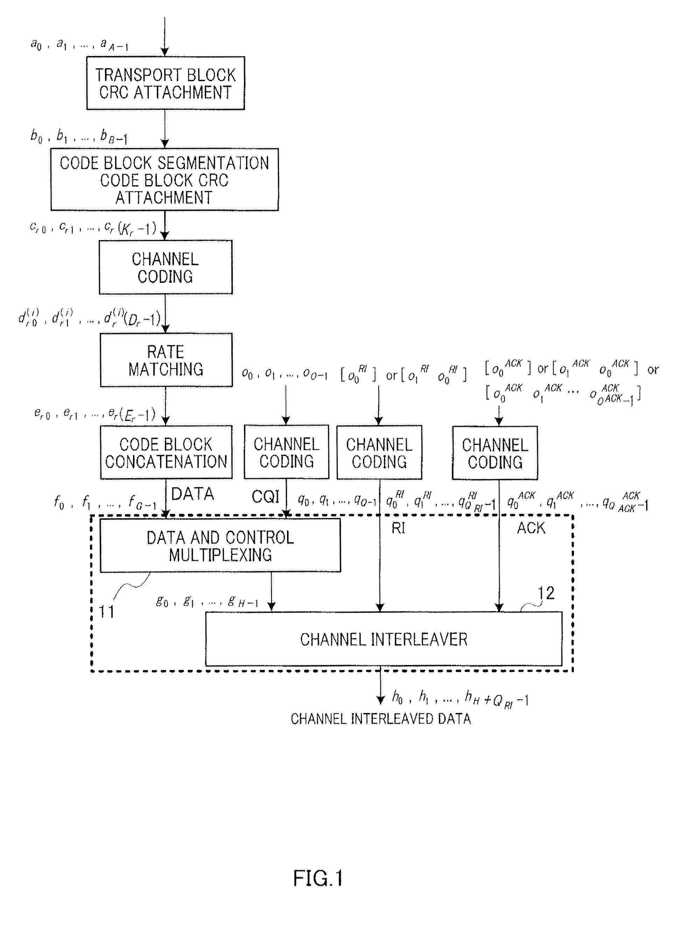

FIG.1 is a diagram illustrating a processing flow of UL-SCH described in Non-Patent Literature 1. The following description assumes that data and control multiplexing 11 and channel interleaver 12 in FIG.1 perform channel interleaving processing. As shown in FIG.1, the channel interleaving processing method described in Non-Patent Literature 1 receives four types of data coded in different processing systems as input, performs channel interleaving processing and outputs channel interleaved data.

Here, the four types of input data refer to UL-SCH data (hereinafter referred to as "DATA"), CQI (channel quality information), hybrid ARQ-ACK (hereinafter referred to as "ACK") and RI (rank indicator).

Such a channel interleaver normally uses a memory, maps data by selecting the bit direction of the memory as the column direction of a channel interleaving matrix and the address direction as the row direction of the channel interleaving matrix, and thereby realizes channel interleaving processing. The row direction of the channel interleaving matrix is handled in units of a modulation symbol made up of a plurality of bits.

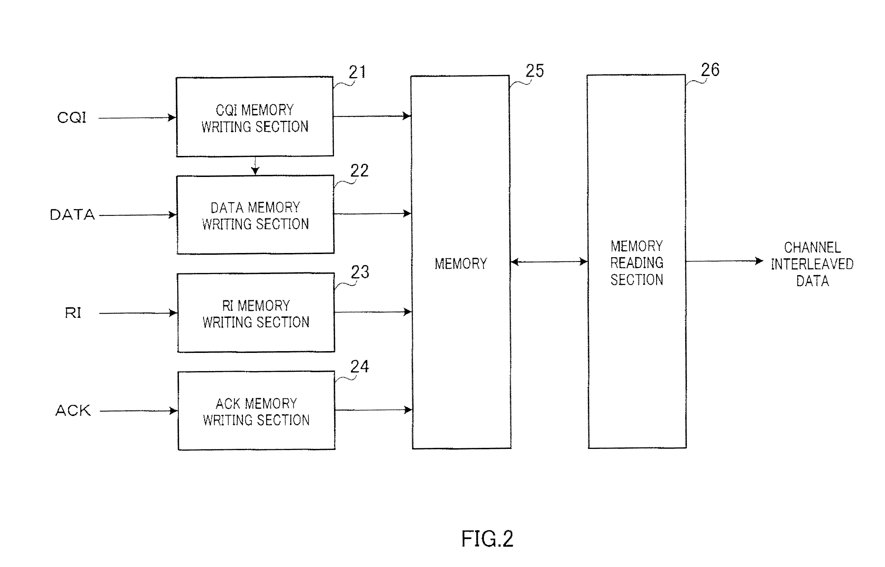

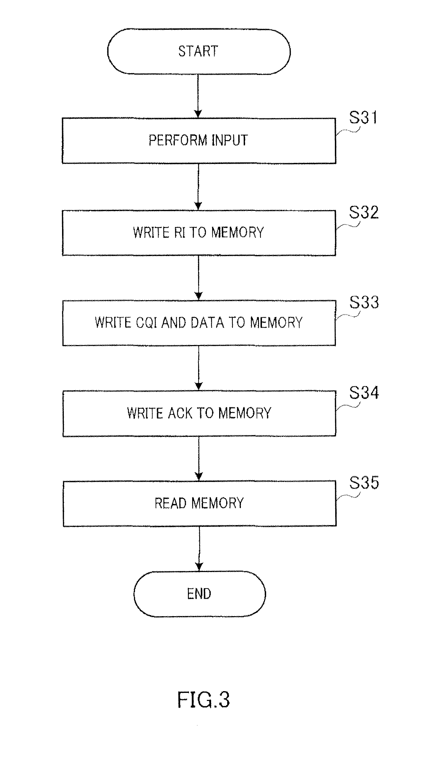

Next, FIG.2 shows a general configuration of a channel interleaver that realizes the channel interleaving processing method described in Non-Patent Literature 1 and operation of the channel interleaver shown in FIG.2 will be described using FIG.3 to FIG.8.

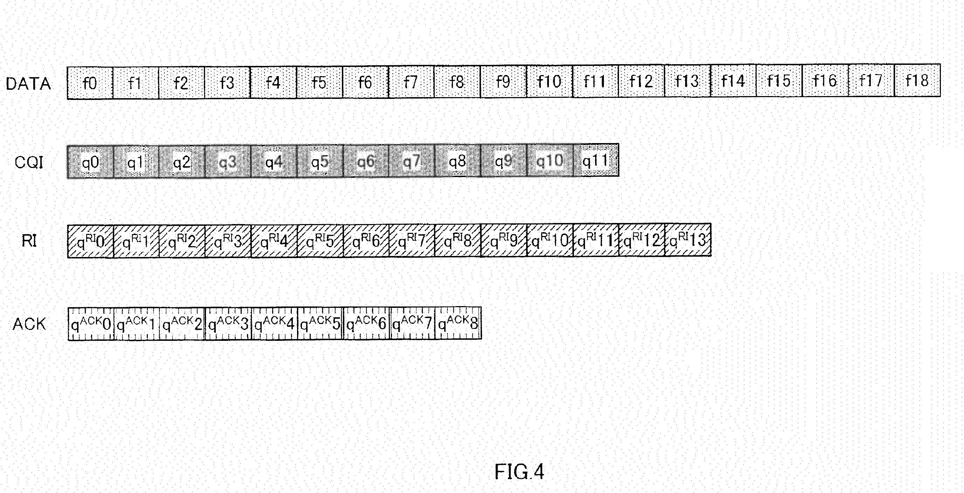

In step S31, CQI is inputted to CQI writing section 21, DATA is inputted to DATA writing section 22, RI is inputted to RI writing section 23 and ACK is inputted to ACK writing section 24. These data pieces are prepared in a buffer or register and FIG.4 shows how these data pieces are prepared.

In the example in FIG.4, DATA is data consisting of 19 symbols of f0, f1,..., f18. Similarly, CQI is data consisting of 12 symbol of q0, q1,..., q11. RI is data consisting of 14 symbols of $q^{RI}0$, $q^{RI}1$,..., $q^{RI}13$. ACK is data consisting of 9 symbols of $q^{ACK}0$, $q^{ACK}1$,...,$q^{ACK}8$.

In step S32, RI memory writing section 23 writes RI to memory 25 selected as a channel interleaving matrix and performs mapping as described in Non-Patent Literature 1. FIG.5 shows a mapping situation at a point in time when step S32 is completed.

In step S33, CQI memory writing section 21 first writes CQI to memory 25 and performs mapping while skipping positions at which RI was already mapped in step S32 as described in Non-Patent Literature 1. Upon completion of the writing of CQI, CQI memory writing section 21 reports information on its completion address number and symbol number to DATA memory writing section 22. Next, DATA memory writing section 22 writes DATA to memory 25 following the last symbol of CQI based on the writing completion address number and symbol number of CQI and performs mapping while skipping positions at which RI was already mapped in step S32 as described in

Non-Patent Literature 1.

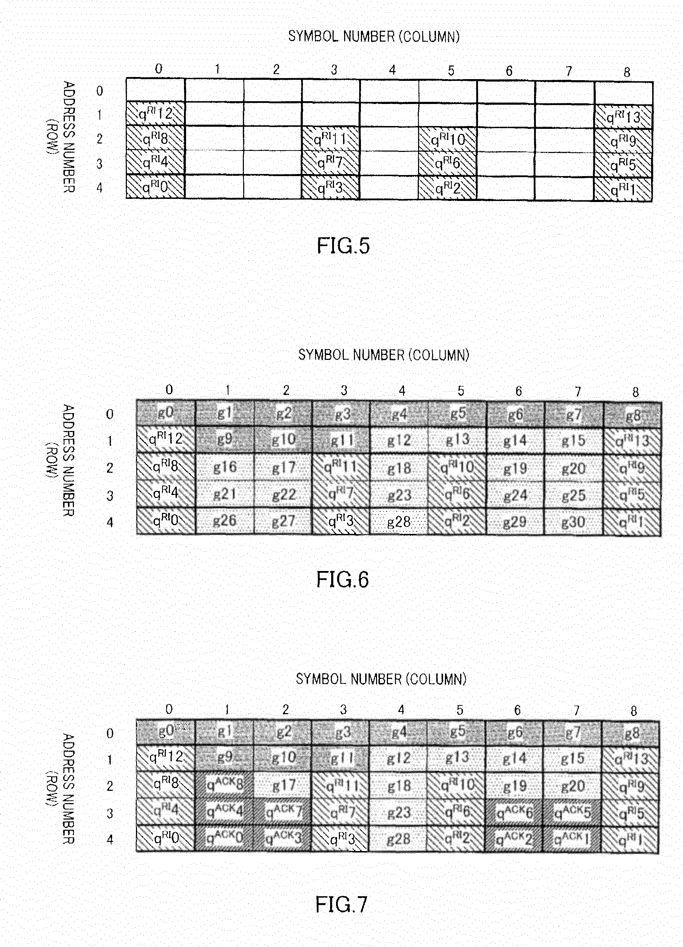

The processing of writing DATA following CQI in step S33 corresponds to the processing in data and control multiplexing 11 in FIG.1. For this reason, data of a total of 31 symbols of q0,q1,..., q11, and f0, f1,..., f18 of CQI and DATA combined in that order is substituted by g0, g1,..., g30. FIG.6 shows a mapping situation at a point in time when step S33 is completed.

In step S34, ACK memory writing section 24 writes ACK to memory 25 and performs overwrite mapping to part of CQI or DATA written to memory 25 as described in Non-Patent Literature 1. FIG.7 shows a mapping situation at a point in time when step S34 is completed.

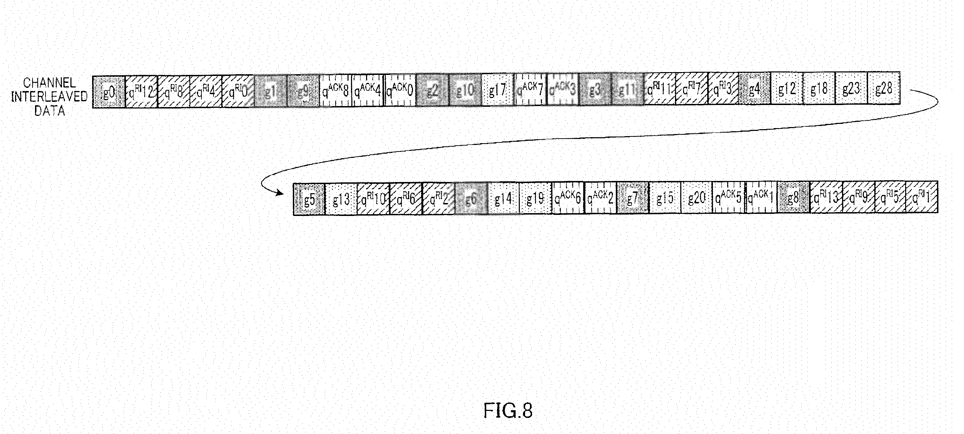

In step S35, memory reading section 26 reads data from memory 25 for each column and outputs the data as channel interleaved data. FIG.8 shows the channel interleaved data.

**EP 2 541 778 A1**

Citation List

Non-Patent Literature

NPL 1
3GPP TS 36.212 V8.4.0 (Figure 5.2.2-1: Transport channel processing for UL-SCH)

Summary of Invention

Technical Problem

However, according to the channel interleaving processing method described in aforementioned Non-Patent Literature 1, as shown in FIG.9, each memory writing section writes RI, CQI, DATA, ACK in that order to memory 25, and memory reading section 26 then reads the data from memory 25. Accordingly, since each process starts after the preceding process ends, the channel interleaving processing takes time.
It is an object of the present invention to provide an interleaving apparatus and an interleaving method that shorten the channel interleaving processing time.

Solution to Problem

An interleaving apparatus of the present invention adopts a configuration including: a memory that stores first data and second data in different regions, respectively; a first writing section that writes the first data to the memory; a second writing section that writes the second data to the memory; a reading section that reads the first data and the second data stored in the memory in order different from the order in which the first data and the second data are written; and a multiplexing section that multiplexes the read first data and second data with third data and fourth data at predetermined timing to form an interleaving pattern.
An interleaving method of the present invention adopts a configuration including the steps of: writing first data to a memory; writing second data concurrently with the writing of the first data to a region of the memory different from the region in which the first data is written; reading the first data and the second data written to the memory in order different from the order in which the first data and the second data are written; and multiplexing the read first data and second data with third data and fourth data at predetermined timing to form an interleaving pattern.

Advantageous Effects of Invention

According to the present invention, it is possible to shorten the channel interleaving processing time.

Brief Description of Drawings

FIG.1 is a diagram illustrating a processing flow of UL-SCH described in Non-Patent Literature 1;
FIG.2 is a block diagram illustrating a general configuration of a channel interleaver that realizes a channel interleaving processing method described in Non-Patent Literature 1;
FIG.3 is a flowchart illustrating operation of the channel interleaver shown in FIG.2;
FIG.4 is a diagram schematically illustrating a process of the channel interleaving processing described in Non-Patent Literature 1;
FIG.5 is a diagram schematically illustrating a process of the channel interleaving processing described in Non-Patent Literature 1;
FIG.6 is a diagram schematically illustrating a process of the channel interleaving processing described in Non-Patent Literature 1;
FIG.7 is a diagram schematically illustrating a process of the channel interleaving processing described in Non-Patent Literature 1;
FIG.8 is a diagram schematically illustrating a process of the channel interleaving processing described in Non-Patent Literature 1;
FIG.9 is a diagram illustrating processing timing of the interleaver shown in FIG.2;
FIG.10 is a block diagram illustrating a configuration of a channel interleaver according to Embodiment 1 of the present invention;
FIG. 11 is a diagram illustrating CQI and DATA mapped to a memory;

FIG.12 is a diagram illustrating a method of multiplexing 2-bit RI with CQI and DATA;

FIG.13 is a diagram illustrating a method of multiplexing 2-bit RI with CQI and DATA;

FIG.14 is a diagram illustrating processing timing of the interleaver shown in FIG.10;

FIG.15 is a block diagram illustrating a configuration of an interleaver according to Embodiment 2 of the present invention;

FIG.16 is a diagram illustrating CQI mapped to a memory;

FIG.17 is a diagram illustrating DATA mapped to a memory;

FIG.18 is a diagram illustrating processing timing of the interleaver shown in FIG.15;

FIG.19 is a block diagram illustrating a configuration of an interleaver according to Embodiment 3 of the present invention;

FIG.20 is a diagram illustrating CQI mapped to a memory;

FIG.21 is a diagram illustrating DATA mapped to a memory;

FIG.22 is a diagram illustrating timing of generating various parameters to illustrate a method of generating a DATA reading address;

FIG.23 is a diagram illustrating an initial address before start DATA reading;

FIG.24 is a diagram illustrating mapping to a channel interleaving matrix before an ACK overwrite;

FIG.25 is a diagram illustrating timing of generating various parameters and symbol types to illustrate the method of generating a DATA reading address; and

FIG.26 is a diagram illustrating processing timing of the interleaver shown in FIG.19.

Description of Embodiments

Hereinafter, embodiments of the present invention will be described in detail with reference to the accompanying drawings. However, components having a function identical among embodiments will be assigned the same reference numerals and overlapping description will be omitted.

(Embodiment 1)

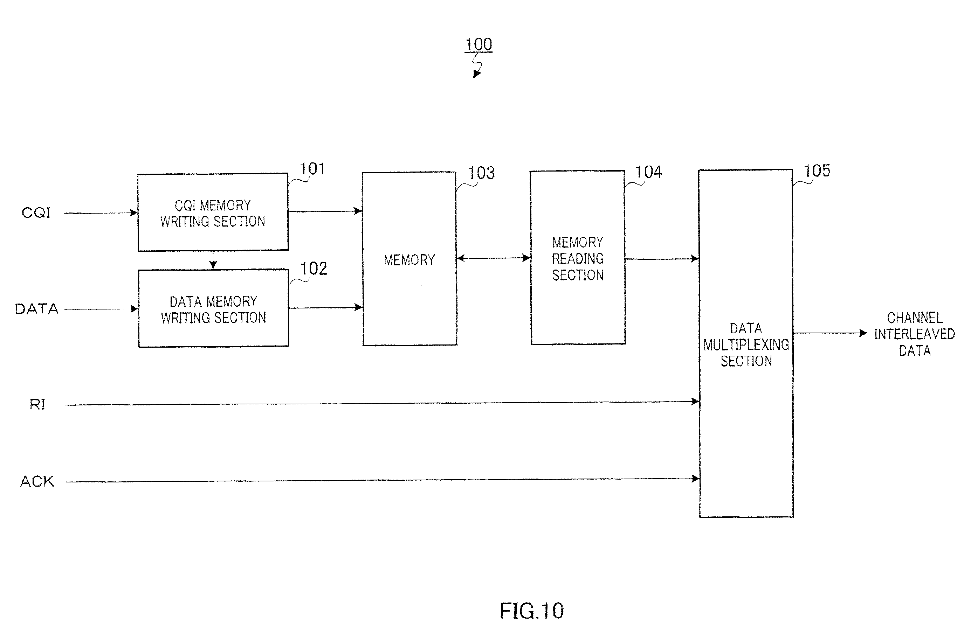

FIG.10 is a block diagram illustrating a configuration of channel interleaver 100 according to Embodiment 1 of the present invention. In this figure, CQI memory writing section 101 writes and maps inputted CQI in symbol units in the row direction from the top of memory 103 selected as a channel interleaving matrix. At this time, in the mapping of the channel interleaving matrix, writing is performed while skipping mapping positions of RI. Upon completion of the writing of CQI, CQI memory writing section 101 reports information on the completion address number and the symbol number to DATA memory writing section 102.

DATA memory writing section 102 writes and maps DATA to memory 103 selected as a channel interleaving matrix in symbol unit in the row direction from the next CQI writing completion address number and symbol number reported from CQI memory writing section 101. At this time, in mapping of the channel interleaving matrix, writing is also performed while skipping the mapping positions of RI.

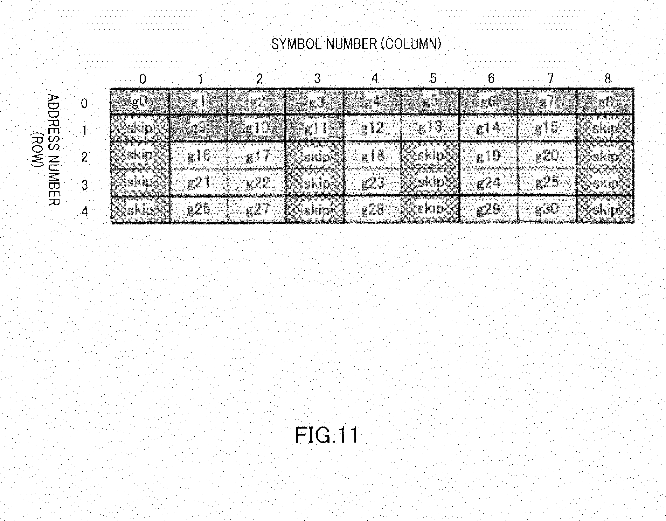

Memory 103 stores the CQI written by CQI memory writing section 101 and the DATA written by DATA memory writing section 102, and memory reading section 104 reads stored CQI and DATA. Memory 103 identifies a row by an address number and a column by a symbol number to thereby manage the mapping positions of data (here, CQI and DATA). FIG.11 shows CQI and DATA mapped to memory 103 when memory 103 is set assuming a channel interleaving matrix of 5 rows and 9 columns. In PIG.11, "skip" denotes a mapping position of RI skipped at the time of data writing.

Memory reading section 104 reads the stored CQI and DATA from memory 103 in symbol units in the column direction from the top of memory 103 according to the mapping of the channel interleaving matrix and outputs the CQI and DATA to data multiplexing section 105.

Data multiplexing section 105 generates RI channel interleaved data. To be more specific, RI has a characteristic of being formed by repeating one or three types of symbol values. The RI channel interleaved data can also be generated by appropriately rearranging the one or three types of symbol values. That is, data multiplexing section 105 takes in symbol values from a register storing the one or three types of symbol values at appropriate timing and in appropriate order, and thereby generates RI channel interleaved data.

Furthermore, data multiplexing section 105 generates ACK channel interleaved data. To be more specific, when the duplex scheme of the system is an FDD (frequency division duplex) scheme, ACK as well as RI also has a characteristic of being formed by repeating one or three types of symbol values, and therefore the ACK channel interleaved data can also be generated by appropriately rearranging the one or three types of symbol values. That is, data multiplexing section 105 takes in symbol values from a register storing the one or three types of symbol values at appropriate timing and in appropriate order, and thereby generates ACK channel interleaved data.

Data multiplexing section 105 multiplexes the CQI and DATA outputted from memory reading section 104, RI channel interleaved data and ACK channel interleaved data, and thereby generates and outputs channel interleaved data.

Here, details of RI being formed by repeating one or three types of symbol values will be described. First, when attention is focused on channel coding of RI shown in FIG.1, this input is $[O_0^{RI}]$ or $[O_1^{RI}O_0^{RI}]$ and the former is called "1-bit RI" and the latter is called "2-bit RI" and these RIs consist of 1 bit and 2 bits respectively. The inputted RI is subjected to channel coding, outputted as $q_0RI$, $q_1RI$,..., $q_Q^{RI}_{RI}$-1 (bit sequence) and has a length of $Q^{RI}$ bits. The method of calculating the length of $Q^{RI}$ bits is defined in Non-Patent Literature 1.

Next, a case where a 1-bit RI is subjected to channel coding will be described more specifically. Table 1 shown below is Table 5.2.2.6-3 described in Non-Patent Literature 1.

[Table 1]

| $Q_m$ | Encoded RI |
|---|---|
| 2 | $[O_0^{RI}y]$ |
| 4 | $[O_0^{RI}yxx]$ |
| 6 | $[O_0^{RI}yxxxx]$ |

In Table 1, $Q_m$ denotes an M-ary modulation number (the number of bits that can be transmitted with 1 symbol), $Q_m$=2 denotes QPSK, $Q_m$=4 denotes 16QAM and $Q_m$=6 denotes 64QAM.

According to Table 1, since encoded RI of the 1-bit RI has a length of 1 symbol, if this is represented by symbol value A, A=$[O_0^{RI}y]$ (2 bits) when $Q_m$=2, A=$[O_0^{RI}yxx]$ (4 bits) when $Q_m$=4 and A=$[O_0^{RI}yxxxx]$ (6 bits) when $Q_m$=6, where y and x are assumed to be arbitrary values.

The channel-encoded RI is outputted as $q_0^{RI}$, $q_1^{RI}$,..., $q_Q^{RI}_{RI}$-1 and this output is obtained by repeating the encoded RI $Q^{RI}/Q_m$ (number of symbols) times and arranging them. That is, $q_0^{RI}$, $q_1^{RI}$,..., $q_Q^{RI}_{RI}$-1 (bit sequence) = $q_0^{RI}$, $q_1^{RI}$,..., $q_Q^{RI}/Q_m$-1RI (symbol column) = A, A,..., A (symbol column), and the total number of As is $Q^{RI}/Q_m$ (number of symbols).

When a 1-bit RI is subjected to channel coding in this way, the channel coding output, that is, the input to the channel interleaver is a repetition of one type of symbol value of A.

Next, a case where a 2-bit RI is subjected to channel coding will be described more specifically. Table 2 shown below is Table 5.2.2.6-4 described in Non-Patent Literature 1.

[Table 2]

| $Q_m$ | Encoded RI |
|---|---|
| 2 | $[O_0^{RI}O_1^{RI}O_2^{RI}O_0^{RI}O_1^{RI}O_2^{RI}]$ |
| 4 | $[O_0^{RI}O_1^{RI}xxO_2^{RI}O_0^{RI}xxO_1^{RI}O_2^{RI}xx]$ |
| 6 | $[O_0^{RI}O_1^{RI}xxxxO_2^{RI}O_0^{RI}xxxxO_1^{RI}O_2^{RI}xxxx]$ |

According to Table 2, since an encoded RI of a 2-bit RI has a length of 3 symbols, if these are represented by symbol value A, symbol value B, symbol value C in order in 1-symbol units, A=$[O_0^{RI}O_1^{RI}]$, B=$[O_2^{RI}O_0^{RI}]$, C=$[O_1^{RI}O_2^{RI}]$ (each having 2 bits) when $Q_m$=2, A=$[O_0^{RI}O_1^{RI}xx]$, B=$[O_2^{RI}O_0^{RI}xx]$, C=$[O_1^{RI}O_2^{RI}xx]$ (each having 4 bits) when $Q_m$=4 and A=$[O_0^{RI}O_1^{RI}xxxx]$, B=$[O_2^{RI}O_0^{RI}xxxx]$, C=$[O_1^{RI}O_2^{RI}xxxx]$ (each having 6 bits) when $Q_m$=6, where x is an arbitrary value. Furthermore, $O_2^{RI}=O_0^{RI}xorO_1^{RI}$(xor: exclusive OR) is defined.

The channel-encoded RI is outputted as $q_0^{RI}$, $q_1^{RI}$,..., $q_Q^{RI}_{RI}$-1 (bit sequence) and this output is obtained by repeating the encoded RI $Q^{RI}/Q_m$ (number of symbols) times and arranging those RIs. That is, $q_0^{RI}$, $q_1^{RI}$,..., $q_Q^{RI}_{RI}$-1 (bit sequence) = $q_0^{RI}$, $q_1^{RI}$,..., $q_Q^{RI}/Q_m$-1RI (symbol column) = A, B, C, A, B, C,..., A, B, C (symbol sequence) and the total number of As, Bs and Cs are $Q^{RI}/Q_m$ (number of symbols). $Q^{RI}/Q_m$ is not necessarily a multiple of 3, and the output may be, for example, A, B, C, A, B, C,...,A, B.

Thus, when the 2-bit RI is subjected to channel coding, the channel coding output, that is, the input to the channel interleaver is a repetition of three types of symbol values of A, B and C.

From the above description, in the case of a 1-bit RI, data multiplexing section 105 calculates and stores one type of symbol value, and in the case of a 2-bit RI, data multiplexing section 105 calculates and stores three types of symbol values. Data multiplexing section 105 then multiplexes the RI symbol values with CQI and DATA at appropriate timing and in appropriate order. This makes it possible to realize channel interleaving without wiiting any RI to memory 103.

In the case of ACK, there are also 1-bit ACK and 2-bit ACK, and ACK is formed by repeating one or three types of symbol values in the same way as the aforementioned RI.

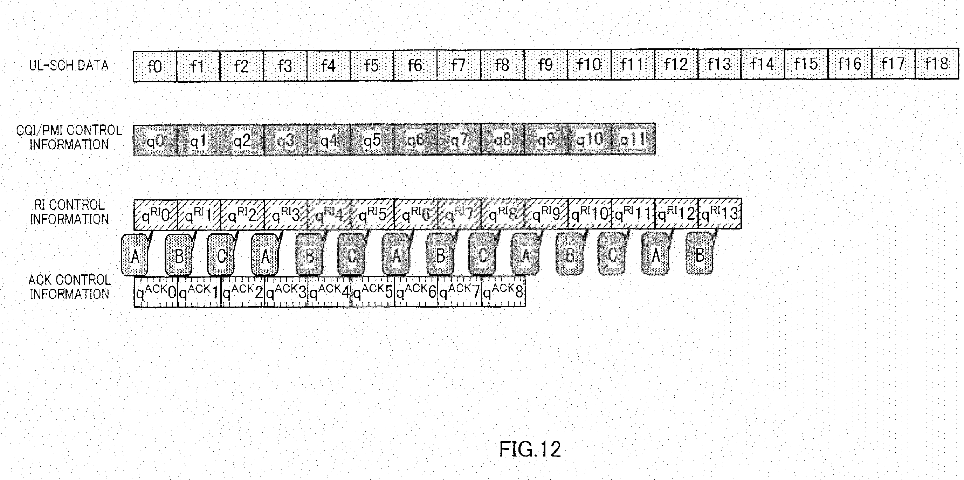

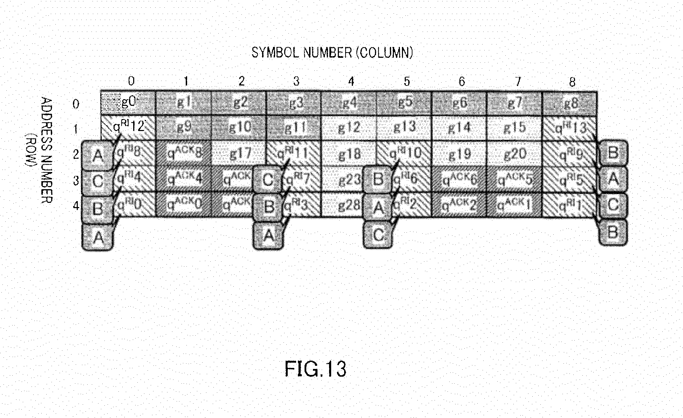

Here, in the case of 2-bit RI, the method whereby data multiplexing section 105 multiplexes A, B and C at appropriate timing and in appropriate order will be described using FIG.12 and FIG.13. In the cases of FIG.12 and FIG. 13, suppose that an instruction (register setting) indicating the following condition is given beforehand from a higher layer: the number of symbols of RI is 14; the number of rows of the channel interleaving matrix is 5; and the number of columns is 9. In FIG.12, suppose that an RI inputted to data multiplexing section 105 is $q_0^{RI}$, $q_1^{RI}$,..., $q_{13}^{RI}$ = A, B, C, A, B, C, A, B, C, A, B, C, A, B.

Furthermore, as shown in FIG.13, Non-Patent Literature 1 describes that when the number of columns of the channel interleaving matrix is 9, RI is mapped in order of symbol numbers (column numbers) 0→8→5→3 from the lowest row (row number 4) upward.

From above, dividing the number of symbols of RI 14 by the number of columns 4 to which RI is mapped gives quotient 3 and remainder 2. The quotient indicates up to which row from the lowest row RI is mapped in all columns of symbol numbers (column numbers) 0, 8, 5 and 3, and the remainder indicates how many RIs are further mapped to the row immediately above. Therefore, in the case of quotient 3 and remainder 2, it is clear that RIs are mapped up to the third row from the lowest row for all symbol numbers 0, 8, 5 and 3, whereas on the fourth row, RIs are mapped to only symbol numbers 0 and 8. That is, it is easily derived that RIs are mapped to four symbols from the lowest row for columns of symbol numbers 0 and 8, and three symbols from the lowest row for columns of symbol numbers 3 and 5. Furthermore, the order of A, B, C is uniquely defined so as to be repeated in the order of A→B→C from the lowest row for row numbers 0 and 3, repeated in the order of C→A→B for row number 5 and repeated in the order of B→C→A for row number 8. Therefore, if the row number and the column number at appropriate timing at which RIs should be multiplexed are known, A, B and C to be multiplexed are uniquely defined.

Thus, data multiplexing section 105 can multiplex A, B and C with the CQI and DATA read from memory 103 at appropriate timing and in appropriate order.

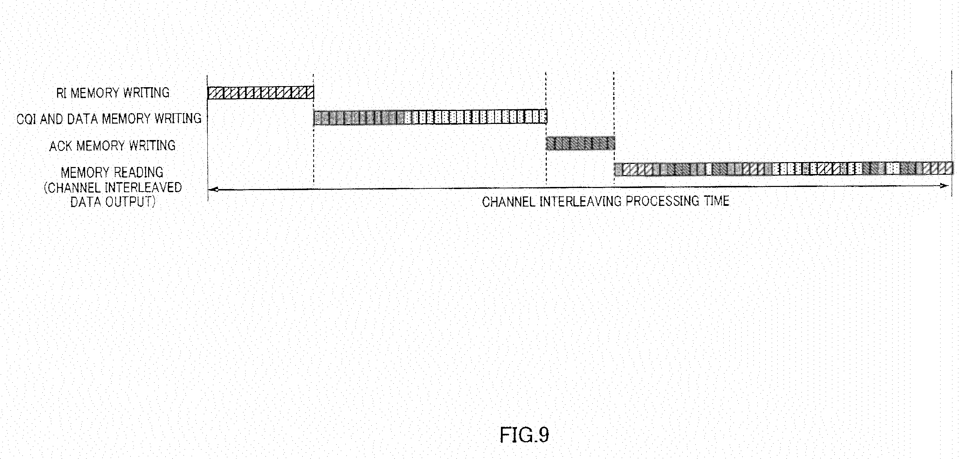

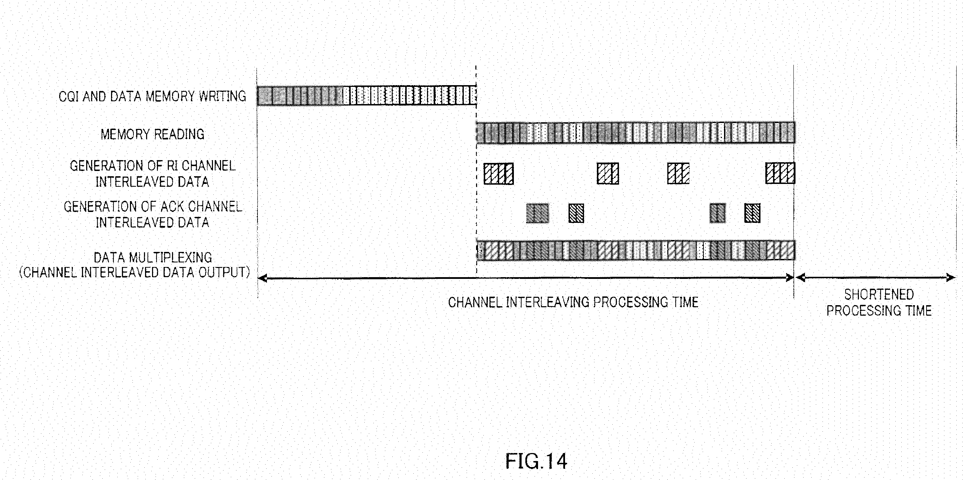

FIG.14 is a diagram illustrating processing timing of interleaver 100 shown in FIG.10. As is apparent from FIG. 14, from a point in time when writing processing of CQI and DATA to memory 103 ends, CQI and DATA are read from memory 103, and RI channel interleaved data and ACK channel interleaved data are multiplexed with the read CQI and DATA to start generating channel interleaved data. It is clear from a comparison between FIG. 14 and FIG.9 that the writing time of RI and ACK to the memory is reduced and the channel interleaving processing time is shortened accordingly.

Thus, according to Embodiment 1, it is possible to eliminate the necessity for the time of writing RI and ACK to the memory and shorten the channel interleaving processing time by writing only CQI and DATA to a memory and multiplexing RI and ACK with the CQI and DATA read from the memory at appropriate timing and in appropriate order.

(Embodiment 2)

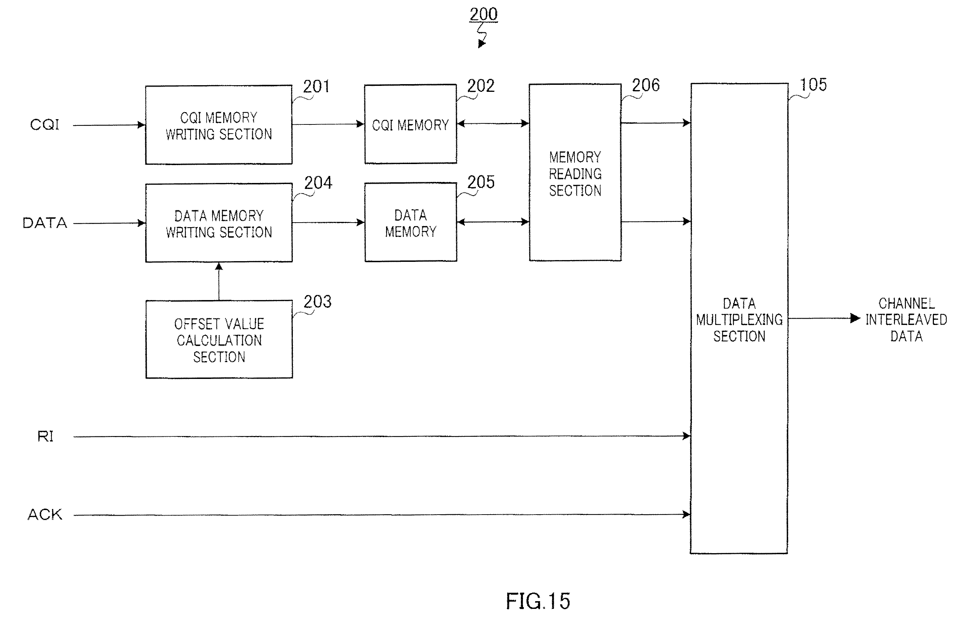

FIG.15 is a block diagram illustrating a configuration of interleaver 200 according to Embodiment 2 of the present invention. FIG.15 is different from FIG.10 in that offset value calculation section 203 is added, CQI memory writing section 101 is changed to CQI memory writing section 201, DATA memory writing section 102 is changed to DATA memory writing section 204, memory 103 is changed to CQI memory 202 and DATA memory 205 and memory reading section 104 is changed to memory reading section 206.

CQI memory writing section 201 writes and maps inputted CQI in symbol units in the row direction from the top of CQI memory 202 selected as a channel interleaving matrix. At this time, in the mapping of the channel interleaving matrix, writing is performed while skipping RI mapping positions.

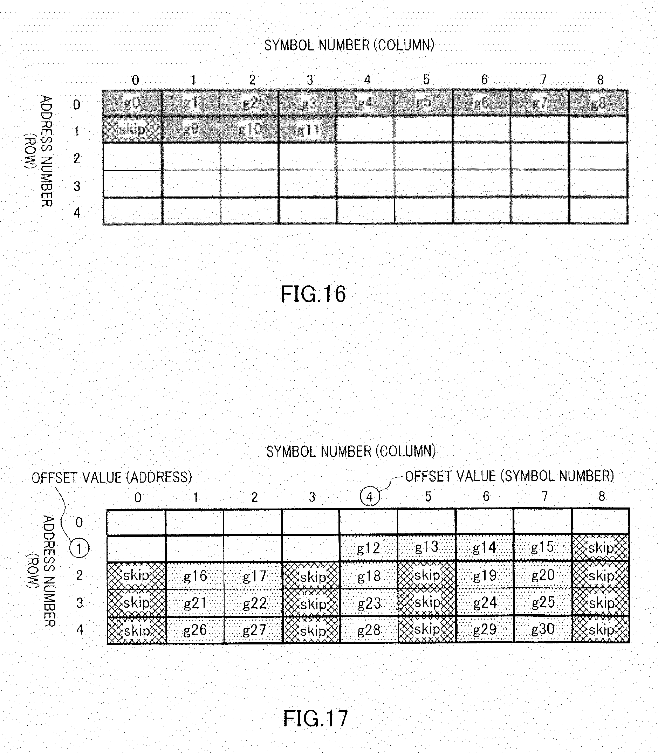

CQI memory 202 stores the CQI written by CQI memory writing section 201 and memory reading section 206 reads the stored CQI. CQI memory 202 identifies a row by an address number and a column by a symbol number to thereby manage CQI mapping positions. FIG.16 shows CQI mapped to CQI memory 202 when CQI memory 202 is set assuming a channel interleaving matrix of 5 rows by 9 columns.

In mapping of the channel interleaving matrix, offset value calculation section 203 calculates a position for mapping the top symbol of DATA (address number and symbol number) and outputs the calculated offset value to DATA memory writing section 204. In an example in FIG.17, the offset value corresponds to an address number (row number) of 1 and a symbol number (column number) of 4. Offset value calculation section 203 can be realized by hardware using a semiconductor such as an LSI or a DSP (digital signal processor) and computation software operating on the DSP or the like, but from the standpoint of the circuit scale, offset value calculation section 203 is preferably realized by a DSP and computation software.

Concurrently with the writing processing of CQI memory writing section 201, DATA memory writing section 204 writes and maps DATA to DATA memory 205 selected as a channel interleaving matrix from the offset value outputted from offset value calculation section 203 in symbol units in the row direction. At this time, in the mapping of the channel interleaving matrix, writing is performed while skipping RI mapping positions.

DATA memory 205 stores the DATA written by DATA memory writing section 204 and memory reading section 206 reads the stored DATA. DATA memory 205 manages DATA mapping positions using address numbers and symbol numbers common to those of CQI memory 202. FIG. 17 shows DATA mapped to DATA memory 205 when DATA memory 205 is set assuming a channel interleaving matrix of 5 rows by 9 columns.

Memory reading section 206 reads the stored CQI from CQI memory 202 and the stored DATA from DATA memory 205 in symbol units in the column direction from the top of each memory according to the mapping of the channel interleaving matrix. At this time, memory reading section 206 outputs the same address to CQI memory 202 and DATA memory 205 regardless of the presence or absence of written data and simultaneously reads data from both memories. The read data is outputted to data multiplexing section 105.

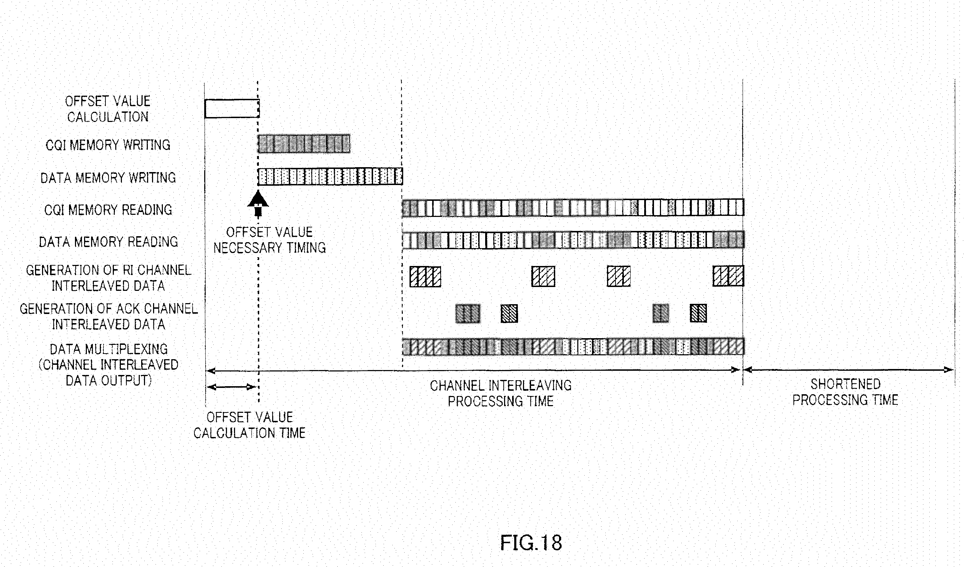

FIG.18 is a diagram illustrating processing timing of interleaver 200 shown in FIG.15. As is clear from FIG.18, interleaver 200 simultaneously starts writing CQI and DATA to the memory from a point in time when the calculation of the offset value ends. Interleaver 200 then reads CQI and DATA from both memories from a point in time when processing of writing DATA to DATA memory 205 ends, and at the same time multiplexes the read CQI and DATA with RI channel interleaved data and ACK channel interleaved data, and starts generating channel interleaved data. It is apparent from a comparison between FIG.18 and FIG.9 that although a new processing time is required to calculate the offset value, writing CQI and DATA to the memories in parallel reduces the CQI writing time. This is because the effect of reducing the CQI writing time is greater even when the increase in the processing time required to calculate the offset value is taken into account. Furthermore, it is apparent that the time for writing RI and ACK to the memory is reduced. In this way, it is clear that the channel interleaving processing time is shortened.

Thus, Embodiment 2 provides the CQI memory and the DATA memory independently, writes CQI and DATA to the memories in parallel, and can thereby reduce the CQI writing time to the memory and shorten the channel interleaving time.

In the present embodiment, a case where CQI memory 202 and DATA memory 205 are provided independently has been described, but these memories may be realized by one memory provided with an arbitration circuit.

(Embodiment 3)

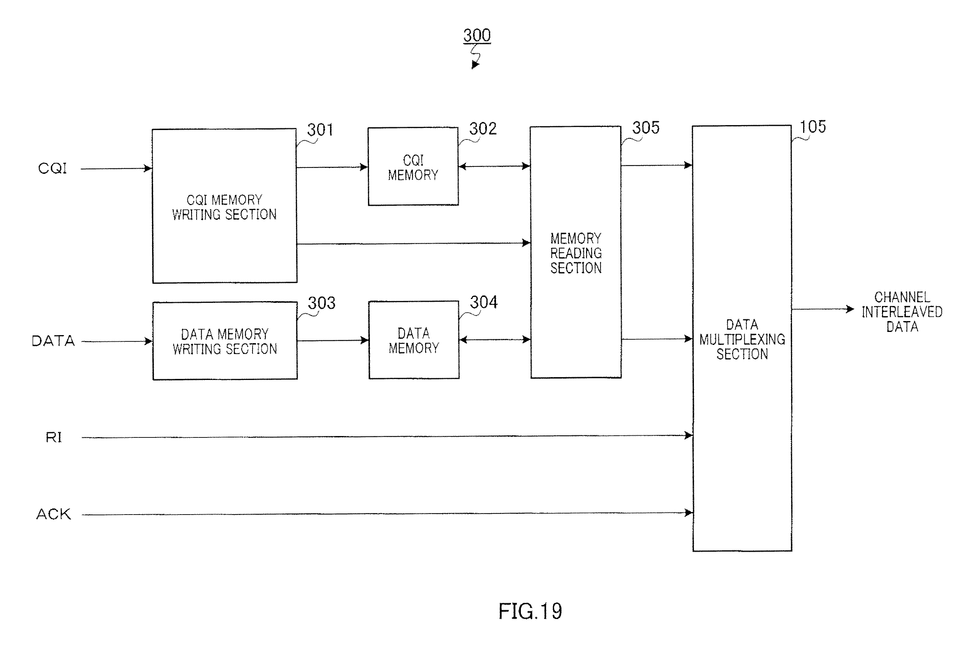

FIG.19 is a block diagram illustrating a configuration of interleaver 300 according to Embodiment 3 of the present invention. FIG.19 is different from FIG.10 in that: CQI memory writing section 101 is changed to CQI memory writing section 301; DATA memory writing section 102 is changed to DATA memory writing section 303; memory 103 is changed to CQI memory 302 and DATA memory 304; and memory reading section 104 is changed to memory reading section 305.

CQI memory writing section 301 writes and maps inputted CQI in symbol units in the row direction from the top of CQI memory 302 selected as a channel interleaving matrix. At this time, in the mapping of the channel interleaving matrix, writing is performed while skipping RI mapping positions. Upon completion of the writing of CQI, CQI memory writing section 301 reports an address number and symbol number of the symbol next to the symbol where the writing is completed to memory reading section 305, as an offset value.

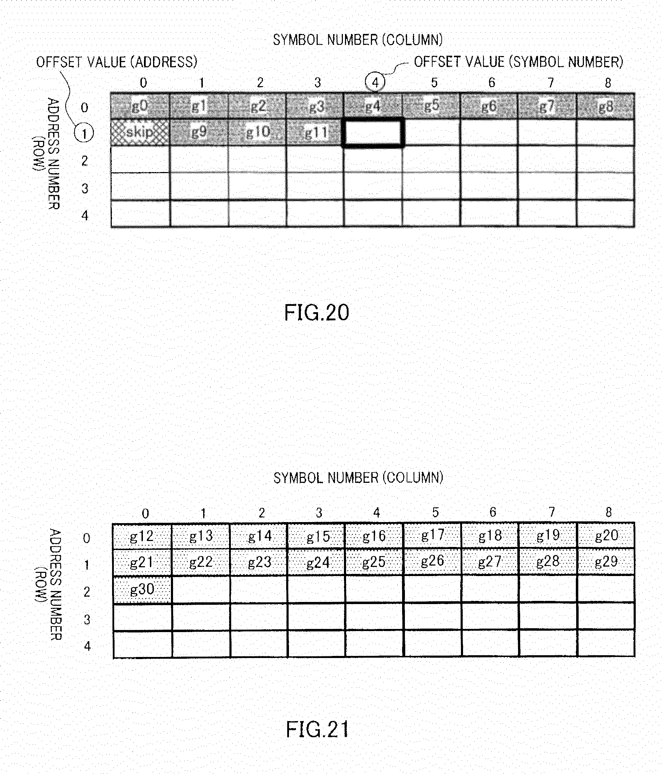

CQI memory 302 stores the CQI written by CQI memory writing section 301 and memory reading section 305 reads the stored CQI. CQI memory 302 identifies a row by an address number and a column by a symbol number to thereby manage CQI mapping positions. FIG.20 shows CQI mapped to CQI memory 302 when CQI memory 302 is set assuming a channel interleaving matrix of 5 rows by 9 columns. In an example in FIG.20, the offset value corresponds to an address number (row number) of 1 and a symbol number (column number) of 4.

DATA memory writing section 303 writes DATA to DATA memory 304 in symbol units in the row direction concurrently with the writing processing of CQI memory writing section 301. At this time, writing is performed successively from the top of the memory without taking into account the mapping of the channel interleaving matrix.

DATA memory 304 stores DATA written by DATA memory writing section 303 and memory reading section 305 reads the stored DATA. DATA memory 304 identifies a row by an address number and a column by a symbol number to thereby manage DATA mapping positions. FIG.21 shows DATA mapped to DATA memory 304.

Memory reading section 305 outputs different addresses to CQI memory 302 and DATA memory 30A irrespective of the presence or absence of written data and reads data from both memories simultaneously. To be more specific, memory reading section 305 reads the stored CQI from CQI memory 302 in symbol units in the column direction from the top of the memory according to the mapping of the channel interleaving matrix. Furthermore, memory reading section 305 generates a DATA reading address using the offset value reported from CQI memory writing section 301 and reads the stored DATA from DATA memory 304 in symbol units. Since DATA memory 304 is not selected as a channel interleaving matrix, memory reading section 305 generates an address so as to produce an effect equivalent to that in the case where DATA memory 304 is selected and used as a channel interleaving matrix, and then reads DATA. The read data is outputted to data multiplexing section 105.

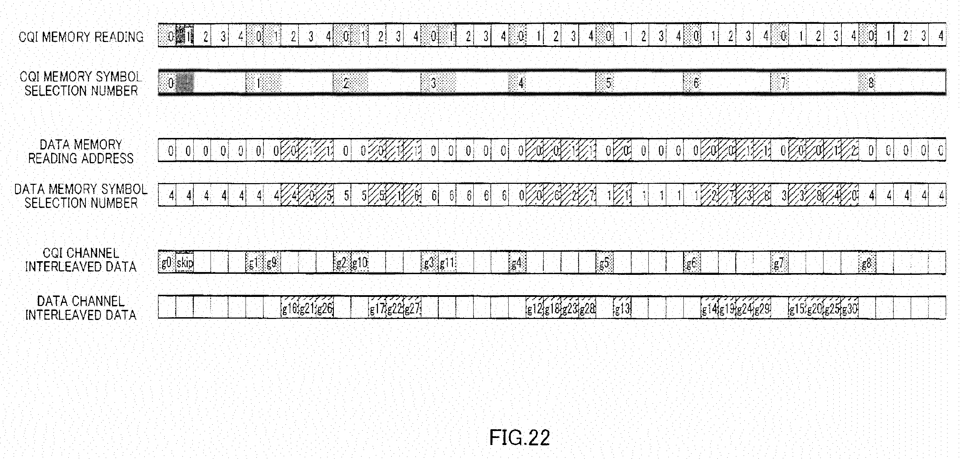

Here, the method of generating a DATA reading address in memory reading section 305 will be described. The method of generating a DATA reading address is divided into two generation methods; one for an initial address before start reading and the other for the next address currently being read. First, the method of generating an initial address before start reading will be described using FIG.22.

FIG.22 is a timing chart indicating timing of generating a CQI memory address number (row number), CQI memory symbol number (column number), DATA memory address number (row number), DATA memory symbol number (column number), CQI channel interleaved data and DATA channel interleaved data.

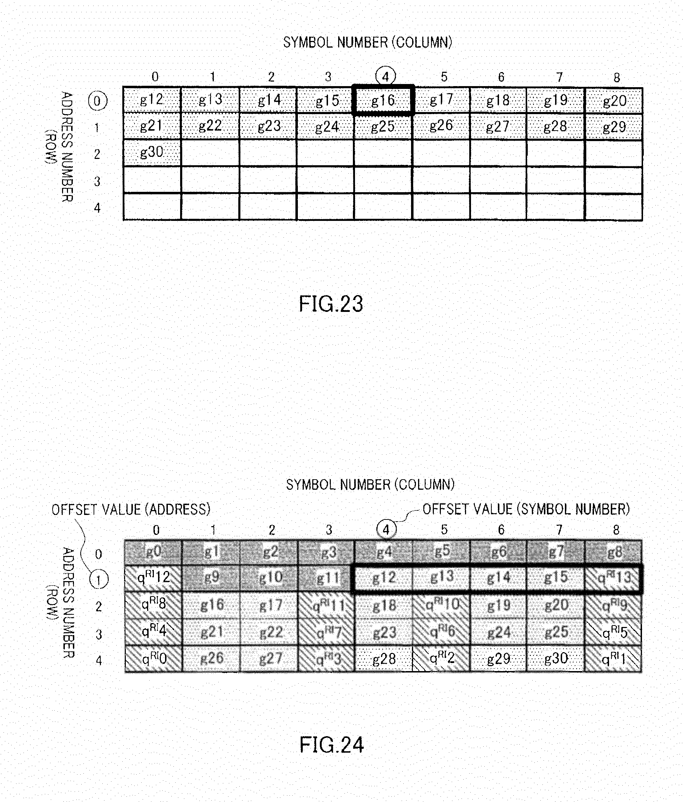

Since the initial address before start reading DATA specifies a DATA symbol to be read first, referring to FIG. 23, the initial address is address number (DADR) 0 and symbol number (DSYM) 4 on the DATA memory that specifies g16. This value is derived before start to read DATA and retained after start reading CQI until the first DATA symbol is read.

According to the specific initial address generation method before start reading DATA, assuming that the address number of the offset value reported from CQI memory writing section 301 is OFA, the symbol number of the offset value is OFS, the number of rows of the channel interleaving matrix is ROW, the number of columns is NSYM and the total number of RI symbols is Q'RI, OFA=1, OFS=4, ROW=5, NSYM=9, Q'RI=14 are obtained in an example in FIG.24.

The values of ROW, NSYM and Q'RI are instructed (register setting) from a higher layer.

Next, the number of RI symbols RIS included in the thick frame of the channel interleaving matrix shown in FIG.24 is calculated. In the example in FIG.24, RIS = 1. The range of the thick frame corresponds to the remaining symbols of the CQI final row and when there is no symbol other than CQI on the CQI final row, RIS=0 is set. Furthermore, RIS can be calculated from OFA, OFS, ROW, NSYM and Q'RI.

Next, the DSYM initial value is calculated from following equation 1. The DADR initial value is always 0.

$$\text{DSYM initial value} = \text{NSYM-OFS-RIS (when OFS} \neq 0)$$

$$\text{DSYM initial value} = 0 \text{ (when OFS} = 0) \quad \dots \text{(Equation 1)}$$

In the case of "g16" in FIG.23, DADR initial value = 0, DSYM initial value = 9-4-1 = 4. It is thus apparent that this result matches the address number (row number) and symbol number (column number) of "g16" in the DATA memory.

Next, the method of generating an address next to the address currently being read will be described. First, it is determined whether or not a symbol corresponding to a CQI memory reading address number (current CADR) and a symbol number (current CSYM) currently being read is located on the lowest row in the mapping of the channel interleaving matrix before an ACK is overwritten. When the symbol is not located on the lowest row, the type of the next symbol (CQI, DATA or RI) is determined. A symbol whose determined symbol type is not DATA, which is data read from DATA memory 304 (dummy data), is multiplexed or overwritten with CQI, RI and ACK in the subsequent processing.

When the CQI memory reading address number currently being read (current CADR) is on the lowest row, the next DADR is always 0. Furthermore, the next DSYM is calculated by one of 20 calculation equations using the next CADR, the address number of the offset value as OFA, the symbol number of the offset value as OFS, the number of rows of the channel interleaving matrix as ROW, the number of columns as NSYM, the total number of RI symbols as Q'RI, and the number of RI symbols included in the thick frame in FIG.24 is RIS. An example of the calculation equations is shown below.

$$\text{Next DSYM} = \text{next CSYM+NSYM-OFS-RIS-1} \quad \dots \text{(Equation 2)}$$

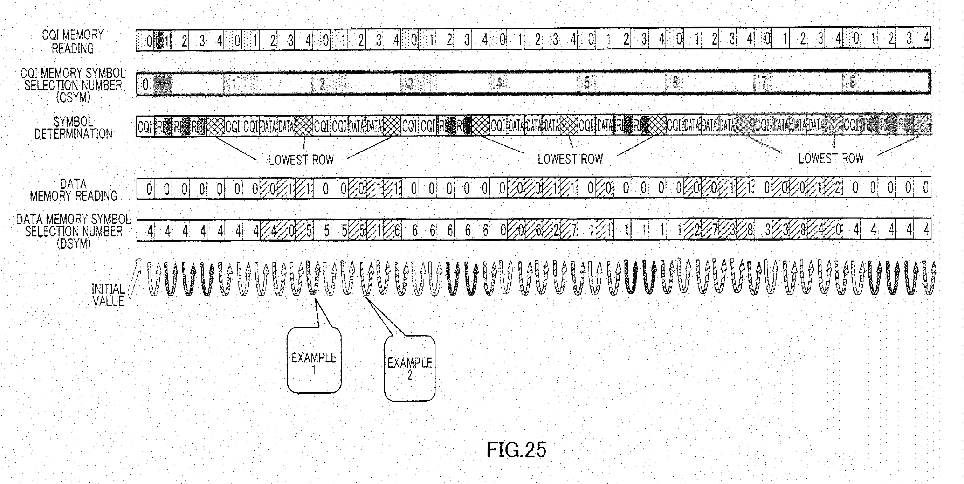

In the case of example 1 shown in FIG.25, next DSYM = 2+9-4-1-1 = 5 (next DADR is 0) according to above equation 2.

Next, when the memory reading address number for a CQI currently being read (current CADR) is not on the lowest row and the next symbol type is CQI or RI, it is always true that next DADR = current DADR, and next DSYM = current DSYM, and the current value is thus continued.

Finally, when the memory reading address number for a CQI currently being read (current CADR) is not on the lowest row and the next symbol type is DATA, the next DADR and next DSYM are calculated by one of 9 calculation equations using current DADR, current DSYM, next CSYM, the number of rows of the channel interleaving matrix as ROW, the number of columns as NSYM, the total number of RI symbols as Q'RI, and the number of RI symbols included in the thick frame in FIG.24 is RIS, An example of the calculation equations is shown below.

$$\text{Next DADR} = \text{current DADR+1, next CSYM} = \text{current DSYM-4} \dots \text{(Equation 3)}$$

EP 2 541 778 A1

In the case of example 2 shown in FIG.25, next DADR = 0+1 = 1, next DSYM = 5-4 = 1 from above equation 3.

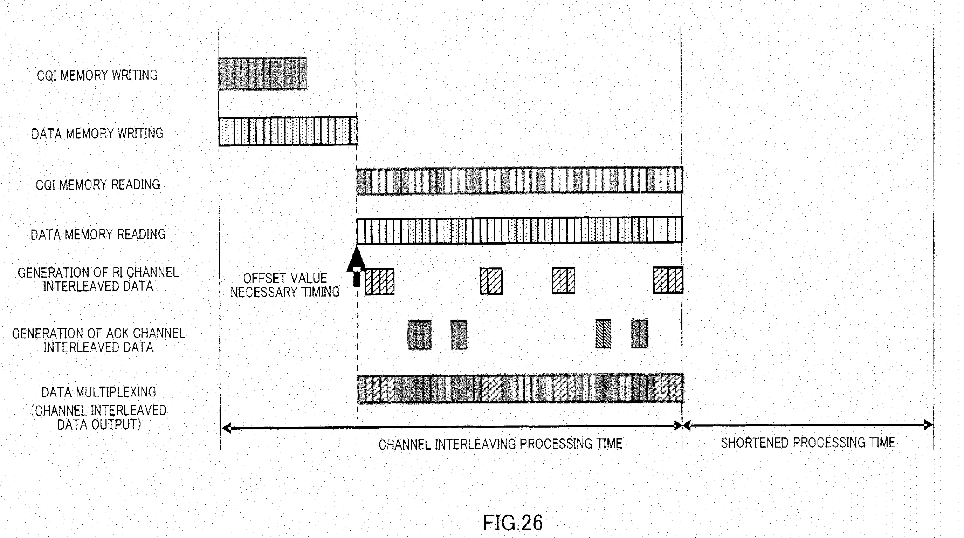

FIG.26 is a diagram illustrating processing timing of the interleaver shown in FIG.19. As is apparent from FIG. 26, the interleaver simultaneously starts writing CQI and DATA to the memory, reads the CQI and DATA from the memory from a point in time when the processing of writing DATA to DATA memory 304 ends, also multiplexes the RI channel interleaved data and ACK channel interleaved data with the read CQI and DATA and starts generating channel interleaved data. It is apparent from a comparison between FIG.26 and FIG.9 that applying parallel processing to writing of CQI and DATA to the memory reduces the CQI writing time. It is also apparent that the time for writing RI and ACK to the memory is reduced. From above, it is apparent that the channel interleaving processing time is reduced.

Thus, Embodiment 3 provides a CQI memory and a DATA memory independently and performs writing of CQI and DATA to the memories in parallel, and can thereby reduce the CQI memory writing time and shorten the channel interleaving time.

In the present embodiment, a case where CQI memory 302 and DATA memory 304 are provided independently has been described, but these memories may also be realized by one memory provided with an arbitration circuit.

The disclosure of Japanese Patent Application No.2010-038888, filed on February 24, 2010, including the specification, drawings and abstract is incorporated herein by reference in its entirety.

Industrial Applicability

The interleaving apparatus and the interleaving method according to the present invention are applicable to a radio communication base station apparatus and a radio communication terminal apparatus or the like in a mobile communication system.

Reference Signs List

101, 201, 301 CQI memory writing section
102, 204, 303 DATA memory writing section
103 memory
104, 206, 305 memory reading section
105 data multiplexing section
202, 302 CQI memory
203 offset value calculation section
205, 304 DATA memory

**Claims**

1. An interleaving apparatus comprising:

   a memory that stores first data and second data in different regions, respectively;
   a first writing section that writes the first data to the memory;
   a second writing section that writes the second data to the memory;
   a reading section that reads the first data and the second data stored in the memory in order different from the order in which the first data and the second data are written; and
   a multiplexing section that multiplexes the read first data and second data with third data and fourth data at predetermined timing to form an interleaving pattern.

2. The interleaving apparatus according to claim 1, wherein the memory includes:

   a first memory that stores the first data; and
   a second memory that stores the second data.

3. The interleaving apparatus according to claim 1, wherein the reading section reads the first data and the second data in ascending order of column numbers for each column and in ascending order of row numbers in each column, the first data and second data being managed according to row numbers and column numbers provided in the memory.

9

4. The interleaving apparatus according to claim 1, further comprising an offset value calculation section that calculates a row number and a column number as an offset value at which writing of the second data is started, the row number and the column number being provided in the memory, wherein
the second writing section starts writing the second data from the calculated offset value concurrently with writing of the first data.

5. The interleaving apparatus according to claim 2, wherein the first writing section calculates an offset value from a row number and a column number provided in the memory at which writing of the first data ends, and the first writing section reports the calculated offset value to the reading section.

6. The interleaving apparatus according to claim 1, wherein
the third data is ACK formed by repeating one or three types of symbol values, and
the fourth data is a rank indicator formed by repeating one or three types of symbol values.

7. An interleaving method comprising the steps of:

writing first data to a memory;
writing second data concurrently with the writing of the first data to a region of the memory different from the region in which the first data is written;
reading the first data and the second data written to the memory in order different from the order in which the first data and the second data are written; and
multiplexing the read first data and second data with third data and fourth data at predetermined timing to form an interleaving pattern.

$a_0, a_1, \dots, a_{A-1}$

TRANSPORT BLOCK
CRC ATTACHMENT

$b_0, b_1, \dots, b_{B-1}$

CODE BLOCK SEGMENTATION
CODE BLOCK CRC
ATTACHMENT

$c_{r0}, c_{r1}, \dots, c_r(K_r-1)$

CHANNEL
CODING

$d_{r0}^{(i)}, d_{r1}^{(i)}, \dots, d_r^{(i)}(D_r-1)$

RATE
MATCHING

$o_0, o_1, \dots, o_{O-1}$   $[o_0^{RI}]$ or $[o_1^{RI} \; o_0^{RI}]$   $[o_0^{ACK}]$ or $[o_1^{ACK} \; o_0^{ACK}]$ or $[o_0^{ACK} \; o_1^{ACK} \dots o_{O_{ACK}-1}^{ACK}]$

$e_{r0}, e_{r1}, \dots, e_r(E_r-1)$

CODE BLOCK
CONCATENATION

CHANNEL
CODING

CHANNEL
CODING

CHANNEL
CODING

$f_0, f_1, \dots, f_{G-1}$   DATA   CQI   $q_0, q_1, \dots, q_{Q-1}$   $q_0^{RI}, q_1^{RI}, \dots, q_{Q_{RI}-1}^{RI}$   $q_0^{ACK}, q_1^{ACK}, \dots, q_{Q_{ACK}-1}^{ACK}$

DATA AND CONTROL
MULTIPLEXING

RI   ACK

11   $g_0, g_1, \dots, g_{H-1}$   12

CHANNEL INTERLEAVER

$h_0, h_1, \dots, h_{H+Q_{RI}-1}$
CHANNEL INTERLEAVED DATA

FIG.1

EP 2 541 778 A1

CQI ⟶ CQI MEMORY WRITING SECTION ~21

DATA ⟶ DATA MEMORY WRITING SECTION ~22

RI ⟶ RI MEMORY WRITING SECTION ~23

ACK ⟶ ACK MEMORY WRITING SECTION ~24

MEMORY ~25

MEMORY READING SECTION ~26

⟶ CHANNEL INTERLEAVED DATA

FIG.2

```
                    ┌──────────────────┐
                    │      START       │
                    └──────────────────┘
                              │
                              ▼
              ┌───────────────────────────────┐  S31
              │        PERFORM INPUT          │
              └───────────────────────────────┘
                              │
                              ▼
              ┌───────────────────────────────┐  S32
              │      WRITE RI TO MEMORY       │
              └───────────────────────────────┘
                              │
                              ▼
              ┌───────────────────────────────┐  S33
              │  WRITE CQI AND DATA TO MEMORY │
              └───────────────────────────────┘
                              │
                              ▼
              ┌───────────────────────────────┐  S34
              │      WRITE ACK TO MEMORY      │
              └───────────────────────────────┘
                              │
                              ▼
              ┌───────────────────────────────┐  S35
              │         READ MEMORY           │
              └───────────────────────────────┘
                              │
                              ▼
                    ┌──────────────────┐
                    │       END        │
                    └──────────────────┘
```

FIG.3

EP 2 541 778 A1

DATA | f0 | f1 | f2 | f3 | f4 | f5 | f6 | f7 | f8 | f9 | f10 | f11 | f12 | f13 | f14 | f15 | f16 | f17 | f18

CQI | q0 | q1 | q2 | q3 | q4 | q5 | q6 | q7 | q8 | q9 | q10 | q11

RI | $q^{RI}0$ | $q^{RI}1$ | $q^{RI}2$ | $q^{RI}3$ | $q^{RI}4$ | $q^{RI}5$ | $q^{RI}6$ | $q^{RI}7$ | $q^{RI}8$ | $q^{RI}9$ | $q^{RI}10$ | $q^{RI}11$ | $q^{RI}12$ | $q^{RI}13$

ACK | $q^{ACK}0$ | $q^{ACK}1$ | $q^{ACK}2$ | $q^{ACK}3$ | $q^{ACK}4$ | $q^{ACK}5$ | $q^{ACK}6$ | $q^{ACK}7$ | $q^{ACK}8$

FIG.4

SYMBOL NUMBER (COLUMN)

| ADDRESS NUMBER (ROW) | 0 | 1 | 2 | 3 | 4 | 5 | 6 | 7 | 8 |
|---|---|---|---|---|---|---|---|---|---|
| 0 | | | | | | | | | |
| 1 | $q^{RI}12$ | | | | | | | | $q^{RI}13$ |
| 2 | $q^{RI}8$ | | | $q^{RI}11$ | | $q^{RI}10$ | | | $q^{RI}9$ |
| 3 | $q^{RI}4$ | | | $q^{RI}7$ | | $q^{RI}6$ | | | $q^{RI}5$ |
| 4 | $q^{RI}0$ | | | $q^{RI}3$ | | $q^{RI}2$ | | | $q^{RI}1$ |

FIG.5

SYMBOL NUMBER (COLUMN)

| ADDRESS NUMBER (ROW) | 0 | 1 | 2 | 3 | 4 | 5 | 6 | 7 | 8 |
|---|---|---|---|---|---|---|---|---|---|
| 0 | g0 | g1 | g2 | g3 | g4 | g5 | g6 | g7 | g8 |
| 1 | $q^{RI}12$ | g9 | g10 | g11 | g12 | g13 | g14 | g15 | $q^{RI}13$ |
| 2 | $q^{RI}8$ | g16 | g17 | $q^{RI}11$ | g18 | $q^{RI}10$ | g19 | g20 | $q^{RI}9$ |
| 3 | $q^{RI}4$ | g21 | g22 | $q^{RI}7$ | g23 | $q^{RI}6$ | g24 | g25 | $q^{RI}5$ |
| 4 | $q^{RI}0$ | g26 | g27 | $q^{RI}3$ | g28 | $q^{RI}2$ | g29 | g30 | $q^{RI}1$ |

FIG.6

SYMBOL NUMBER (COLUMN)

| ADDRESS NUMBER (ROW) | 0 | 1 | 2 | 3 | 4 | 5 | 6 | 7 | 8 |
|---|---|---|---|---|---|---|---|---|---|
| 0 | g0 | g1 | g2 | g3 | g4 | g5 | g6 | g7 | g8 |
| 1 | $q^{RI}12$ | g9 | g10 | g11 | g12 | g13 | g14 | g15 | $q^{RI}13$ |
| 2 | $q^{RI}8$ | $q^{ACK}8$ | g17 | $q^{RI}11$ | g18 | $q^{RI}10$ | g19 | g20 | $q^{RI}9$ |
| 3 | $q^{RI}4$ | $q^{ACK}4$ | $q^{ACK}7$ | $q^{RI}7$ | g23 | $q^{RI}6$ | $q^{ACK}6$ | $q^{ACK}5$ | $q^{RI}5$ |
| 4 | $q^{RI}0$ | $q^{ACK}0$ | $q^{ACK}3$ | $q^{RI}3$ | g28 | $q^{RI}2$ | $q^{ACK}2$ | $q^{ACK}1$ | $q^{RI}1$ |

FIG.7

FIG.8

RI MEMORY WRITING

CQI AND DATA MEMORY WRITING

ACK MEMORY WRITING

MEMORY READING
(CHANNEL INTERLEAVED
DATA OUTPUT)

CHANNEL INTERLEAVING PROCESSING TIME

FIG.9

EP 2 541 778 A1

FIG.10

EP 2 541 778 A1

SYMBOL NUMBER (COLUMN)

| | | 0 | 1 | 2 | 3 | 4 | 5 | 6 | 7 | 8 |
|---|---|---|---|---|---|---|---|---|---|---|
| ADDRESS NUMBER (ROW) | 0 | g0 | g1 | g2 | g3 | g4 | g5 | g6 | g7 | g8 |
| | 1 | skip | g9 | g10 | g11 | g12 | g13 | g14 | g15 | skip |
| | 2 | skip | g16 | g17 | skip | g18 | skip | g19 | g20 | skip |
| | 3 | skip | g21 | g22 | skip | g23 | skip | g24 | g25 | skip |
| | 4 | skip | g26 | g27 | skip | g28 | skip | g29 | g30 | skip |

FIG.11

UL-SCH DATA | f0 | f1 | f2 | f3 | f4 | f5 | f6 | f7 | f8 | f9 | f10 | f11 | f12 | f13 | f14 | f15 | f16 | f17 | f18

CQI/PMI CONTROL INFORMATION | q0 | q1 | q2 | q3 | q4 | q5 | q6 | q7 | q8 | q9 | q10 | q11

RI CONTROL INFORMATION | $q^{RI}0$ | $q^{RI}1$ | $q^{RI}2$ | $q^{RI}3$ | $q^{RI}4$ | $q^{RI}5$ | $q^{RI}6$ | $q^{RI}7$ | $q^{RI}8$ | $q^{RI}9$ | $q^{RI}10$ | $q^{RI}11$ | $q^{RI}12$ | $q^{RI}13$

A | B | C | A | B | C | A | B | C | A | B | C | A | B

ACK CONTROL INFORMATION | $q^{ACK}0$ | $q^{ACK}1$ | $q^{ACK}2$ | $q^{ACK}3$ | $q^{ACK}4$ | $q^{ACK}5$ | $q^{ACK}6$ | $q^{ACK}7$ | $q^{ACK}8$

FIG.12

FIG.13

CQI AND DATA MEMORY WRITING

MEMORY READING

GENERATION OF RI CHANNEL
INTERLEAVED DATA

GENERATION OF ACK CHANNEL
INTERLEAVED DATA

DATA MULTIPLEXING
(CHANNEL INTERLEAVED DATA OUTPUT)

CHANNEL INTERLEAVING PROCESSING TIME

SHORTENED
PROCESSING TIME

FIG.14

EP 2 541 778 A1

FIG.15

SYMBOL NUMBER (COLUMN)

|  | 0 | 1 | 2 | 3 | 4 | 5 | 6 | 7 | 8 |
|---|---|---|---|---|---|---|---|---|---|
| 0 | g0 | g1 | g2 | g3 | g4 | g5 | g6 | g7 | g8 |
| 1 | skip | g9 | g10 | g11 |  |  |  |  |  |
| 2 |  |  |  |  |  |  |  |  |  |
| 3 |  |  |  |  |  |  |  |  |  |
| 4 |  |  |  |  |  |  |  |  |  |

ADDRESS NUMBER (ROW)

FIG.16

SYMBOL NUMBER (COLUMN)

OFFSET VALUE (ADDRESS)                    OFFSET VALUE (SYMBOL NUMBER)

|  | 0 | 1 | 2 | 3 | ④ | 5 | 6 | 7 | 8 |
|---|---|---|---|---|---|---|---|---|---|
| 0 |  |  |  |  |  |  |  |  |  |
| ① |  |  |  |  | g12 | g13 | g14 | g15 | skip |
| 2 | skip | g16 | g17 | skip | g18 | skip | g19 | g20 | skip |
| 3 | skip | g21 | g22 | skip | g23 | skip | g24 | g25 | skip |
| 4 | skip | g26 | g27 | skip | g28 | skip | g29 | g30 | skip |

ADDRESS NUMBER (ROW)

FIG.17

FIG.18

FIG.19

EP 2 541 778 A1

SYMBOL NUMBER (COLUMN)

OFFSET VALUE (ADDRESS) — OFFSET VALUE (SYMBOL NUMBER)

| ADDRESS NUMBER (ROW) | 0 | 1 | 2 | 3 | (4) | 5 | 6 | 7 | 8 |
|---|---|---|---|---|---|---|---|---|---|
| 0 | g0 | g1 | g2 | g3 | g4 | g5 | g6 | g7 | g8 |
| (1) | skip | g9 | g10 | g11 | | | | | |
| 2 | | | | | | | | | |
| 3 | | | | | | | | | |
| 4 | | | | | | | | | |

FIG.20

SYMBOL NUMBER (COLUMN)

| ADDRESS NUMBER (ROW) | 0 | 1 | 2 | 3 | 4 | 5 | 6 | 7 | 8 |
|---|---|---|---|---|---|---|---|---|---|
| 0 | g12 | g13 | g14 | g15 | g16 | g17 | g18 | g19 | g20 |
| 1 | g21 | g22 | g23 | g24 | g25 | g26 | g27 | g28 | g29 |
| 2 | g30 | | | | | | | | |
| 3 | | | | | | | | | |
| 4 | | | | | | | | | |

FIG.21

FIG.22

SYMBOL NUMBER (COLUMN)

| | | 0 | 1 | 2 | 3 | ④ | 5 | 6 | 7 | 8 |
|---|---|---|---|---|---|---|---|---|---|---|
| ADDRESS NUMBER (ROW) | ⓪ | g12 | g13 | g14 | g15 | **g16** | g17 | g18 | g19 | g20 |
| | 1 | g21 | g22 | g23 | g24 | g25 | g26 | g27 | g28 | g29 |
| | 2 | g30 | | | | | | | | |
| | 3 | | | | | | | | | |
| | 4 | | | | | | | | | |

FIG.23

SYMBOL NUMBER (COLUMN)

OFFSET VALUE (ADDRESS)  ⌐OFFSET VALUE (SYMBOL NUMBER)

| | | 0 | 1 | 2 | 3 | ④ | 5 | 6 | 7 | 8 |
|---|---|---|---|---|---|---|---|---|---|---|
| ADDRESS NUMBER (ROW) | 0 | g0 | g1 | g2 | g3 | g4 | g5 | g6 | g7 | g8 |
| | ① | q$^{RI}$12 | g9 | g10 | g11 | **g12** | **g13** | **g14** | **g15** | **q$^{RI}$13** |
| | 2 | q$^{RI}$8 | g16 | g17 | q$^{RI}$11 | g18 | q$^{RI}$10 | g19 | g20 | q$^{RI}$9 |
| | 3 | q$^{RI}$4 | g21 | g22 | q$^{RI}$7 | g23 | q$^{RI}$6 | g24 | g25 | q$^{RI}$5 |
| | 4 | q$^{RI}$0 | g26 | g27 | q$^{RI}$3 | g28 | q$^{RI}$2 | g29 | g30 | q$^{RI}$1 |

FIG.24

FIG.25

EP 2 541 778 A1

CQI MEMORY WRITING

DATA MEMORY WRITING

CQI MEMORY READING

DATA MEMORY READING

GENERATION OF RI CHANNEL
INTERLEAVED DATA

OFFSET VALUE
NECESSARY TIMING

GENERATION OF ACK CHANNEL
INTERLEAVED DATA

DATA MULTIPLEXING
(CHANNEL INTERLEAVED
DATA OUTPUT)

CHANNEL INTERLEAVING PROCESSING TIME

SHORTENED PROCESSING TIME

FIG.26

**EP 2 541 778 A1**

<table>
<tr><td colspan="2"><strong>INTERNATIONAL SEARCH REPORT</strong></td><td>International application No.<br>PCT/JP2011/001079</td></tr>
</table>

A. CLASSIFICATION OF SUBJECT MATTER
*H03M13/27(2006.01)i*

According to International Patent Classification (IPC) or to both national classification and IPC

B. FIELDS SEARCHED

Minimum documentation searched (classification system followed by classification symbols)
H03M13/27

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | WO 2009/041783 A1 (SAMSUNG ELECTRONICS),<br>02 April 2009 (02.04.2009),<br>page 12; fig. 8<br>& JP 2010-541368 A        & EP 2043290 A2 &<br>& AU 2008304051 A        & CN 101809885 A<br>& KR 10-2010-0057918 A | 1,2,7<br>3-6 |
| A | JP 7-312562 A  (Hitachi Kokusai Electric Inc.),<br>25 November 1995 (25.11.1995),<br>paragraphs [0031] to [0044]; fig. 1, 2<br>(Family: none) | 1-7 |

☐ Further documents are listed in the continuation of Box C.    ☐ See patent family annex.

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>10 March, 2011 (10.03.11) | Date of mailing of the international search report<br>29 March, 2011 (29.03.11) |
|---|---|
| Name and mailing address of the ISA/<br>Japanese Patent Office | Authorized officer |
| Facsimile No. | Telephone No. |

Form PCT/ISA/210 (second sheet) (July 2009)

32

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010038888 A